# EUROPÄISCHE PATENTSCHRIFT

(11) **EP 3 589 775 B1**
(45) Veröffentlichungstag und Bekanntmachung des Hinweises auf die Patenterteilung: **18.11.2020**
(21) Anmeldenummer: 18706756.6
(22) Anmeldetag: 27.02.2018
(51) Int. Cl.: C23C 16/02, C23C 16/27

(54) **SCHNEIDPLATTE UND HERSTELLUNGSVERFAHREN**
CUTTING PLATE AND METHOD OF MANUFACTURING SAME
PLAQUE DE DÉCOUPAGE ET PROCÉDÉ DE FABRICATION

(30) Priorität: 02.03.2017 EP 17158791
(43) Veröffentlichungstag der Anmeldung: 08.01.2020
(73) Patentinhaber: Hilti Aktiengesellschaft, 9494 Schaan (LI)
(72) Erfinder: SURBERG, Cord-Henrik, 6800 Feldkirch (AT); ROSIWAL, Stefan, 96049 Bamberg (DE); HELMREICH, Thomas, 90475 Nürnberg (DE)
(74) Vertreter: Hilti Aktiengesellschaft Corporate Intellectual Property
(86) Internationale Anmeldenummer: PCT/EP2018/054753
(87) Internationale Veröffentlichungsnummer: WO 2018/158221

(56) Entgegenhaltungen:
- US-A- 5 391 422
- US-A- 5 776 355
- J BAREIB ET AL: "CVD diamond coating of steel on a CVD-TiBN interlayer", SURFACE AND COATINGS TECHNOLOGY, Bd. 201, Nr. 3-4, 5. Oktober 2006 (2006-10-05), Seiten 718-723, XP055004829, ISSN: 0257-8972, DOI: 10.1016/j.surfcoat.2005.12.035
- HUANG H H ET AL: "Effect of NH"3 on the growth characterization of TiN films at low temperature", JOURNAL OF CRYSTAL GR, ELSEVIER, AMSTERDAM, NL, Bd. 240, Nr. 3-4, 1. Mai 2002 (2002-05-01) , Seiten 513-520, XP004351456, ISSN: 0022-0248, DOI: 10.1016/S0022-0248(02)01081-3

## Beschreibung

### GEBIET DER ERFINDUNG

Die vorliegende Erfindung betrifft Schneidplatten zum spanendenden Bearbeiten von mineralischen Baustoffen, insbesondere von stahlarmierten Beton. Ferner betrifft die Erfindung ein Herstellungsverfahren für eine solche Schneidplatte. Relevanter Stand der Technik ist in dem Dokument US 5 391 422 A offenbart.

### OFFENBARUNG DER ERFINDUNG

Die erfindungsgemäße Schneidplatte hat einen Grundkörper aus einem gesinterten Hartmetall. Die Oberseite des Grundkörpers ist strukturiert. Die Oberseite weist in einem mittleren Abstand von 50 µm bis 250 µm zueinander Erhebung auf. Eine Höhe der Erhebungen liegt im Bereich zwischen 1/8 und 1/2 des Abstands der Erhebungen. Die Erhebungen sind vorzugsweise gleich und vorzugsweise einem regelmäßigen geometrischen Muster folgend angeordnet. Auf der Oberseite des Grundkörpers sind ein oder mehrere Zwischenschichten, welche eine Haftvermittlungsschicht aufweisen. Die Haftvermittlungsschicht ist aus einem borhaltigen Nitrid eines Übergangsmetalls der Gruppe IV, Gruppe V und Gruppe VI und enthält eine Vielzahl zu der Oberseite geneigt orientierter, lenticularer Plättchen. Eine auf der Haftvermittlungsschicht aufgewachsene Diamantschicht hat zu der Oberseite vertikal orientierte, Stängel-förmige Kristalle, deren Aspektverhältnis vorzugsweise größer drei, beispielsweise größer fünf ist. Eine Höhe der Stängel erreicht vorzugsweise bis zu 100 µm.

Die makroskopische Strukturierung der Oberseite erhöht die Haftfestigkeit der Diamantschicht.

Eine Ausgestaltung sieht vor, dass die Oberseite des Grundkörpers sehr rau auf einer Skala von 1 mm ist. Eine gemittelte Rautiefe Rz nach DIN ISO 4287 definiert für eine Messstrecke mit einer Länge von 800 µm beträgt wenigstens 5 µm, vorzugsweise höchstens 12 µm.

Ausgestaltungen der Erfindung sehen vor, dass die Stängel-förmigen Kristalle zueinander parallel sein können, eine Höhe der Stängel-förmigen Kristalle gleich einer Höhe der Diamantschicht sein kann, die Stängel-förmigen Kristalle über Korngrenzen aneinander angrenzen können, die Stängel-förmigen Kristalle etwa den gleichen Durchmesser aufweisen.

Ein erfindungsgemäßes Herstellungsverfahren für eine Schneidplatte, insbesondere eine Schneidplatte für eine Kernbohrkrone sieht folgende Schritte vor. Ein Grundkörper wird aus einem Hartmetall geformt. Eine Oberseite wird unter Ausbildung von Erhebungen strukturiert. Der mittlere Abstand der Erhebungen liegt zwischen 50 µm und 250 µm und deren Höhe liegt zwischen 12,5 % und 50 % des mittleren Abstands. Der Grundkörper kann vor dem Strukturieren oder nach dem Strukturieren gesintert werden. Ein oder mehreren Zwischenschichten einschließlich einer Haftvermittlungsschicht werden auf die strukturierte Oberseite des Grundkörpers mittels eines Gasabscheideverfahrens (CVD) abgeschieden. Das Abscheiden der Haftvermittlungsschicht aus bohrhaltigen Nitriden von Übergangsmetallen umfasst die Teilschritte: Abscheiden von Nitriden eines oder mehrerer Übergangsmetalle aus der Gruppe IV, Gruppe V und Gruppe VI des Periodensystems bei einer Temperatur zwischen 950°C und 1100°C zum Ausbilden einer Vielzahl zu der Oberseite geneigt orientierter Plättchen. Ein Aufwachsen der Diamantschicht auf der Haftvermittlungsschicht umfasst die Teilschritte: Bekeimen der Haftvermittlungsschicht mit Diamantstaub und Aufwachsen von Stängel-förmigen Diamanten aus der Gasphase auf der Haftvermittlungsschicht.

Die makroskopische Strukturierung der Oberseite erhöht die Stabilität der Diamantschicht.

Die Oberseite des Grundkörpers kann vor dem Aufbringen der Zwischenschichten aufgeraut werden, bis sich eine hohe Rauheit einstellt. Eine gemittelte Rautiefe Rz definiert für eine Messstrecke mit einer Länge von 800 µm beträgt wenigstens 5 µm, vorzugsweise höchstens 12 µm.

Die Schneidplatte hat die Oberseite, eine der Oberseite im Wesentlichen gegenüberliegende parallele Rückseite, und eine zu der Oberseite und Rückseite geneigte umlaufende Mantelfläche. Die Mantelfläche kann in gleicherweise wie die Oberseite strukturiert und beschichtet sein.

### KURZE BESCHREIBUNG DER FIGUREN

Die nachfolgende Beschreibung erläutert die Erfindung anhand von exemplarischen Ausführungsformen und Figuren. In den Figuren zeigen:
- Fig. 1: eine ständergeführte Kernbohrmaschine
- Fig. 2: eine Teilansicht einer Kernbohrkrone
- Fig. 3: einen schematischen Querschnitt durch eine Schneidplatte der Kernbohrkrone
- Fig. 4: eine schematische Oberseite eines Grundkörpers,
- Fig. 5: eine lichtmikroskopische Abbildung der Oberseite des Grundkörpers,
- Fig. 6: eine Abbildung der Oberseite mit einer Haftvermittlungsschicht,
- Fig. 7: eine Abbildung der Oberseite mit einer Haftvermittlungsschicht,
- Fig. 8: eine Abbildung der Oberseite mit einer dünnstängeligen Diamantschicht,
- Fig. 9: einen Querschliff durch eine Schneidplatte
- Fig. 10: eine Schneidplatte mit strukturierter Grundplatte
- Fig. 11: eine Schneidplatte ohne strukturierter Grundplatte

Gleiche oder funktionsgleiche Elemente werden durch gleiche Bezugszeichen in den Figuren indiziert, soweit nicht anders angegeben.

### AUSFÜHRUNGSFORMEN DER ERFINDUNG

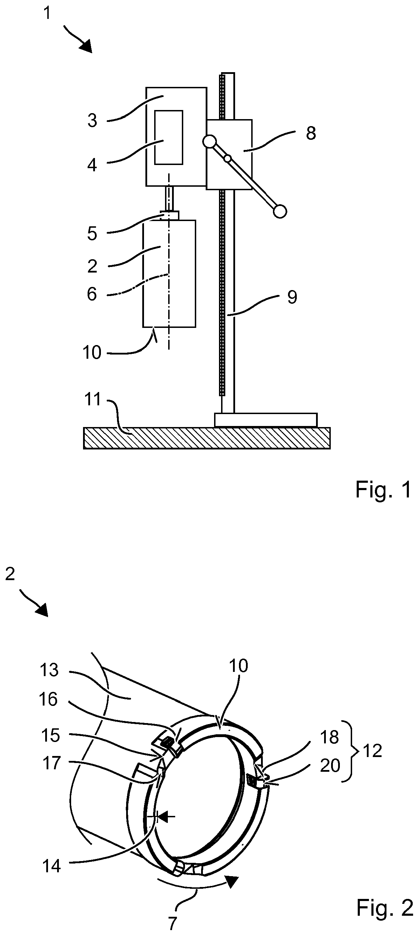

Fig. 1 zeigt beispielhaft eine ständergeführte Kernbohrmaschine **1** mit einer Kernbohrkrone **2.** Die Kernbohrmaschine **1** hat eine Antriebseinheit **3** mit einem Motor **4.** Die Antriebseinheit **3** kann neben dem Motor **4** unter Anderem ein Getriebe und eine Sicherheitskupplung enthalten. Der Anwender kann den Motor **4** durch einen Betriebsschalter einschalten und ausschalten. Die Antriebseinheit **3** dreht einen Werkzeughalter **5** um eine Arbeitsachse **6.** Die Kernbohrkrone **2** kann, koaxial zu der Arbeitsachse **6** ausgerichtet, in den Werkzeughalter **5** eingehängt und verriegelt werden. Der Werkzeughalter **5** überträgt das Drehmoment der Antriebseinheit **3** auf die Kernbohrkrone **2,** welche sich somit um die Arbeitsachse **6** in einer Umlaufrichtung **7** dreht. Die Antriebseinheit **3** ist an einem Schlitten **8** aufgehängt, der parallel zu der Arbeitsachse **6** entlang einer Ständers **9** verfahrbar ist. Beispielsweise kann der Anwender mittels einer Kurbel den Schlitten **8** verschieben, alternativ kann ein Motor mit geeigneter Steuerung den Schlitten **8** bewegen. Die schneidende Stirnfläche **10** der Kernbohrkrone **2** wird mit einem konstanten Anpressdruck an einen zu bearbeitenden Untergrund **11** angepresst. Die Kernbohrkrone **2** hat mehrere in die Stirnfläche **10** eingesetzte Schneidplatten **12,** die einen kreisförmigen Schlitz in den Untergrund **11** schneiden. Die Schneidplatten **12** sind für die Bearbeitung von mineralischen Bauwerkstoffen, insbesondere für stahlarmierten Beton, ausgelegt.

Fig. 2 zeigt eine beispielhafte Stirnfläche **10** der Kernbohrkrone **2.** Die Kernbohrkrone **2** hat ein zylindrisches Rohr **13,** das in der ringförmigen Stirnfläche **10** endet. Der Durchmesser des Rohrs **13** und der Stirnfläche **10** variiert nach Anwendungsgebiet. Typische Durchmesser liegen im Bereich von 5 cm bis 1 m. Die Wandstärke **14** des Rohrs **13** ist typischerweise zwischen 1 mm und 8 mm.

Die Stirnfläche **10** ist durch mehrere in Umlaufrichtung **7** angeordneten Aussparungen **15** unterbrochen. Die Aussparungen **15** haben in Umlaufrichtung **7** aufeinanderfolgend eine von der Stirnfläche **10** abfallende, steile Flanke **16** und eine zu der Stirnfläche **10** hin ansteigende, flache Flanke **17.** Die steile Flanke **16** ist beispielsweise parallel oder um weniger als 10 Gad zu der Arbeitsachse **6** geneigt. Die flache Flanke **17** verläuft mit einer mittleren Steigung von weniger als 45 Grad, z.B. von mehr als 30 Grad, und vorzugsweise wenigstens 10 Grad von der steilen Flanke **16** bis zu der Stirnfläche **10.**

Die Schneidplatte **12** ist in die Aussparung **15** eingesetzt. Die Schneidfläche **18** der Schneidplatte **12** weist in die Umlaufrichtung **7,** vorzugsweise ist die Schneidfläche **18** senkrecht zu der Umlaufrichtung **7** orientiert. Die Schneidplatte **12** hat einen weitgehend prismatischen Aufbau, d.h. eine Rückseite **19** der Schneidplatte **12** hat die gleiche oder eine geringfügig kleinere Fläche wie die Schneidfläche **18.** Die umlaufende Mantelfläche **20** der Schneidplatte **12** ist senkrecht oder näherungsweise senkrecht zu der Schneidfläche **18.** Die Mantelfläche **20** der beispielhaften Schneidplatte **12** ist um wenigstens 75 Grad, vorzugsweise wenigstens 80 Grad, beispielsweise höchstens 85 Grad, gegenüber der Schneidfläche **18** geneigt.

Die Rückseite **19** der Schneidplatte **12** liegt flächig an der steilen Flanke **16** der Aussparung **15** an. Die Schneidplatte **12** liegt vorzugsweise mit wenigstens 75 % ihrer Rückseite an dem Rohr **13** an, um die Schneidplatte **12** bei einwirkenden Stöße während des Bearbeitens von Bauwerkstoffen, insbesondere beim plötzlichen Eingreifen in Armierungseisen, abzustützen. Die Rückseite **19** kann mit dem Rohr **13** verlötet oder verschweißt sein. Die in Umlaufrichtung **7** weisende Schneidfläche **18** liegt weitgehend frei. Die flache Flanke **16** und die Schneidfläche **18** begrenzen einen Volumen, das gegenüber der Stirnfläche **10** zurückgesetzt ist. Die Schneidplatte **12** steht längs der Arbeitsachse **6** über die Stirnfläche **10** hinaus. Der axiale Überstand liegt im Bereich von 0,1 mm bis 1 mm. Eine Breite der Schneidplatte **12** kann größer als die Wandstärke **14** des Rohrs **13** sein, wodurch die Schneidplatte **12** in radialer Richtung, vorzugsweise nach innen zu der Arbeitsachse **6** und nach außen von der Arbeitsachse **6** weg, übersteht. Der radiale Überstand liegt vorzugsweise im Bereich zwischen 0,1 mm und 0,5 mm.

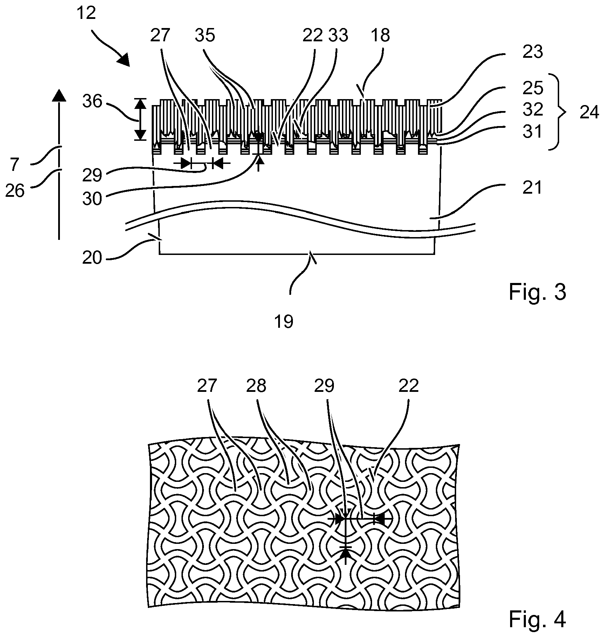

Die Schneidplatte 12 hat einen Grundkörper 21 und auf einer Oberseite 22 des Grundkörpers 21 eine Diamantschicht 23, welche die Schneidfläche 18 bildet (Fig. 3). Ein oder mehrere Zwischenschichten 24, beispielhaft drei Zwischenschichten 24, sind zwischen dem Grundkörper 21 und der Diamantschicht 23 angeordnet. Die Zwischenschichten 24 ermöglichen prozesstechnisch die Diamantschicht 23 abzuscheiden und auch eine robuste, insbesondere eine stoßfeste Anbindung der Diamantschicht 23 an den Grundkörper 21. Dies gilt insbesondere für die an die Diamantschicht 23 angrenzende Zwischenschicht, welche nachfolgend als Haftvermittlungsschicht **25** bezeichnet wird. Die Zwischenschichten **24,** einschließlich der Haftvermittlungsschicht **25,** und die Diamantschicht **23** sind nacheinander in einer Wachstumsrichtung **26** auf den Grundkörper **21** abgeschieden. Die Schneidplatte **12** wird vorzugsweise derart in das Werkzeug eingesetzt, dass deren Arbeitsrichtung, hier die Umlaufrichtung **7,** parallel zu der Wachstumsrichtung **26** ist.

Der beispielhafte Grundkörper **21** bildet den größten Teil der Schneidplatte **12** und legt die Form und Abmessungen der Schneidplatte **12** fest, insbesondere der Rückseite **19** und der Mantelfläche **20.** Der Grundkörper **21** gibt der Schneidplatte **12** die notwendige mechanische Stabilität, insbesondere schützt der Grundkörper **21** die Diamantschicht **23** vor Biege- und Scherkräften beim Bearbeiten von mineralischen Bauwerkstoffen. Zudem ist der Grundkörper **21** ausreichend hart, um ein Durchbiegen der Diamantschicht **23** beim Bearbeiten von mineralischen Bauwerkstoffen zu verhindern.

Der Grundkörper **21** besteht weitgehend aus einem gesinterten Hartmetall. Ein bevorzugtes Hartmetall beinhaltet Körner aus Wolframkarbid, welche in einer metallischen Matrix eingebettet sind. Der Volumenanteil der Körner ist größer als 70 Gewichtsprozent (Gew.-%), vorzugsweise größer oder gleich 80 Gew.-%, und geringer als 95 Gew.-%. Die metallische Matrix besteht beispielsweise aus Kobalt oder einer Kobaltbasierten Legierung. Die Körner des Hartmetalls können neben oder anstelle von Wolframkarbid aus anderen Karbiden und/oder Karbonitriden von Übergangsmetallen der Gruppe IV, Gruppe V und der Gruppe VI des chemischen Periodensystems bestehen. Insbesondere können dem Wolframkarbid Körner aus Titannitrid, Titankarbonitrid, Tantalkarbid beigemengt sein, die sich durch ihre hohe Härte auszeichnen.

Der Volumenanteil der metallischen Matrix ist nahe der Oberseite **22** nicht reduziert. Insbesondere ist die Kobalt-haltige Legierung nicht durch ätzende Verfahren herausgelöst, wodurch die Oberseite **22** porös würde. Das Hartmetall ist an der Oberseite **22** gleichermaßen verdichtet, wie innerhalb des Grundkörpers **21.** Der Volumenanteil der metallischen Matrix ist vorzugsweise in der Wachstumsrichtung **26** konstant.

Die Oberseite **22** des Grundkörpers **21** ist mit einem Muster strukturiert (Fig. 4). Das Muster besteht aus Erhebungen **27** und zwischen den Erhebungen **27** verlaufenden Gräben **28.** Die Gräben **28** können nach dem Sintern in die Oberseite **22** gefräst, geschliffen oder spanend eingebracht werden. Die Oberseite **22** kann auch per Ablation oder anderen geeignete Verfahren durch einen Laser bearbeitet werden. Alternativ kann die Oberseite **22** vor dem Sintern strukturiert werden. Die Oberseite **22** kann nach dem Verpressen des Grünlings gefräst, geschliffen, oder sonstig spanend bearbeitet werden, gleichfalls können die Gräben per Laser eingebracht werden. Ferner kann die Oberseite **22** mittels eines Stempels beim Verpressen mit den gewünschten Erhebungen **27** versehen werden.

Die schematisch dargestellte Oberseite **22** zeigt inselförmige Erhebungen **27.** Jede der Erhebungen **27** ist von den sich kreuzenden Gräben **28** umschlossen. Eine Gruppe der Gräben **28** verläuft im Wesentlichen senkrecht zu der anderen Gruppe von Gräben **28.** Die Gräben können wie dargestellt im Wesentlichen parallel zueinander verlaufen. Alternativ verlaufen die Gräben parallel oder senkrecht zu Rand der Oberseite **22.** Die beispielhaften Gräben **28** sind wellenförmig ausgebildet. Die Erhebungen **27** haben entsprechend geschwungene Ränder. In anderen Ausführungen sind die Gräben geradlinig, die Erhebungen **27** können eine quadratische, rechteck-förmige, dreieck-förmige, etc. Grundfläche aufweisen. Die Erhebungen **27** haben jeweils etwa ähnliche Abmessungen in den zueinander vertikalen Richtungen entlang der Oberseite **22.** Ein Verhältnis der Abmessungen liegt vorzugsweise im Bereich zwischen 1:1 und 1:3. In einer Ausgestaltung sind die alle Gräben zueinander parallel. Die Erhebungen sind entsprechend länglich.

Die gemäß dem Muster angeordneten Erhebungen **27** haben einen Abstand **29** zu ihren benachbarten Erhebungen **27.** Der Abstand **29** ist auf die jeweiligen Schwerpunkte der Erhebungen **27** bezogen. Ein mittlerer Abstand **29** liegt im Bereich zwischen 50 µm und 250 µm. Der Abstand **29** ist für alle Erhebungen **27** vorzugsweise etwa gleich. Insbesondere können die Erhebungen **27** innerhalb von Abschnitten der Oberseite **22** auf einem regelmäßigen Raster angeordnet sein. Die Abstände **29** können beispielsweise äquidistant längs einer Richtung und ebenfalls äquidistant in der dazu senkrechten Richtung angeordnet sein. Ferner können die Abstände längs einer Richtung äquidistant sein und in konstanten Winkel bezogen auf ein Zentrum angeordnet sein, insbesondere entlang von gekrümmten Rändern der Oberseite **22.**

Die Erhebungen **27** sind im Wesentlichen gleich hoch. Die Höhe der Erhebungen **27** ist geringer als deren mittlerer Abstand **29,** vorzugsweise ist die Höhe geringer als die Hälfte des mittleren Abstands **29** und vorzugsweise ist die Höhe **30** größer als ein Achtel des mittleren Abstands **29.**

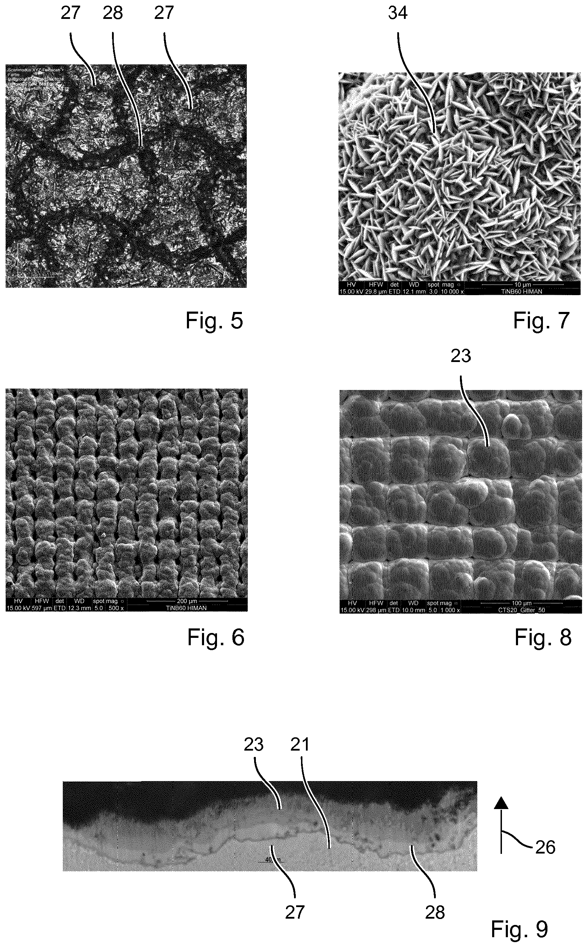

Die Oberseite **22** mit den Erhebungen **27** ist vorzugsweise aufgeraut (Fig. 5). Die Rauheit kann durch den arithmetischen Mittenrauwert Ra und die gemittelte Rautiefe Rz angegeben werden. Die Rauheit des Grundkörpers **21** wird über eine Messstrecke bestimmt, deren Länge auf 800 µm festgelegt ist. Bei dem arithmetischen Mittenrauwert Ra wird das arithmetische Mittel der betragsmäßigen Abweichung der punktuellen Höhe der Oberseite **22** innerhalb der Messstrecke von einer mittleren Höhe auf der Messstrecke ermittelt. Das Höhenprofil der Erhebungen **27** gegenüber den Gräben **28** wird dabei ausgeblendet. Dies kann beispielsweise numerisch durch einen entsprechenden Hochpassfilter oder durch Ausblenden von Messpunkten in den Gräben **28** erfolgen. Der arithmetische Mittenrauwert Ra der Oberseite **22** ist größer als 0,7 µm, vorzugsweise größer 1,0 µm, und geringer als 2,3 µm, vorzugsweise geringer als 1,9 µm. Die gemittelte Rautiefe Rz ist das arithmetische Mittel der Differenz der Höhe der größten Profilspitzen und der Tiefe des größten Profiltals innerhalb von fünf der Messstrecken. Die Oberseite **22** ist vorzugsweise sehr schroff, daher ergibt sich eine deutlich höhere gemittelte Rautiefe Rz gegenüber dem arithmetischen Mittenrauwert Ra. Die gemittelte Rautiefe Rz liegt im Bereich zwischen 5 µm und 13 µm, vorzugsweise größer als 6 µm, vorzugsweise geringer als 9 µm. Die Rauheit kann durch ein geeignetes Partikelstrahlverfahren, d.h. Druckluftstrahlen mit einem körnigen Abrasivmittel, der Erhebungen **27** der Oberseite **22** eingestellt werden. Das Partikelstrahlverfahren wird vorzugsweise auf den gesinterten Grundkörper **21** angewandt. Das Partikelstrahlverfahren wird solange angewandt, bis die gewünschte Rauheit erreicht ist und dann beendet. Die Oberfläche der Erhebungen **27** und auch der Gräben **28** wird aufgeraut, jedoch ohne einen wesentlichen Abtrag des Volumens der Erhebungen **27** zu erwirken.

Eine dünne Barriereschicht **31** kann unmittelbar auf dem Hartmetall an der Oberseite **22** des Grundkörpers **21** aufgewachsen sein. Die Barriereschicht **31** hat eine Stärke zwischen 0,1 µm und 2,0 µm und deckt die Oberseite **22** vollständig ab. Die Barriereschicht **31** soll eine Diffusionsbarriere für Kohlenstoff darstellen, um ein Austreten des Kohlenstoffs aus dem Hartmetall zu unterbinden. Die Barriereschicht **31** soll gut an dem Hartmetall haften und die gesamte Härte des Bauteils möglichst wenig reduzieren. Als besonders geeignet erweist sich hierfür Titannitrid, welches bereits bei einer geringen Schichtdicke von 0,3 µm eine ausreichend Diffusionsbarriere ausbildet. Zudem haftet Titannitrid gut auf Wolframkarbidbasierten Hartmetallen.

Eine Kohlenstoff-haltige Promotionsschicht **32** kann auf der Barriereschicht **31** aus der Gasphase aufgewachsen. Die Promotionsschicht **32** ist beispielsweise zwischen 0,5 µm und 3 µm stark. Die bevorzugte Promotionsschicht **32** besteht aus einem Karbid und/oder Karbonitrid des Übergangsmetalls der Barriereschicht **31,** z.B. Titankarbid bzw. Titankarbonitrid. Anstelle oder zusätzlich zu dem Übergangsmetall der Barriereschicht **31** können die Karbide und/oder Karbonitride von Übergangsmetallen der Gruppe IV, Gruppe V und Gruppe VI abgeschieden werden.

Die Zwischenschichten **24** enthalten eine Haftvermittlungsschicht **25,** welche das Aufwachsen der Diamanten in gewünschter Weise ermöglicht. Die Haftvermittlungsschicht **25** hat eine hohe Mikrorauheit an ihrer der Diamantschicht **23** zugewandten Kontaktseite **33.** Die Rauheit ergibt sich durch eine Struktur von im Wesentlichen vertikal zu der Oberseite **22** orientierten, dünnen Plättchen **34.** Die Plättchen **34** bestehen weitgehend aus einem oder mehreren Nitriden der Übergangsmetalle der Gruppe IV, Gruppe V und Gruppe VI. Das Übergangsmetall ist vorzugsweise Titan, insbesondere wenn die vorhergehenden Zwischenschichten **24** Titan-basiert sind. Die Plättchen **34** enthalten vorzugsweise keinen Kohlenstoff und kein Karbid. Das molare Verhältnis von Kohlenstoff zu Stickstoff kann in den Plättchen **34** deutlich geringer als eins zu zwanzig sein und können auf Verunreinigungen in der Reaktionskammer oder Diffusionsprozesse aus der Diamantabscheidung zurückzuführen sein. Die schmalen Seiten oder Kanten der Plättchen **34,** welche zu der Diamantschicht **23** weisen, enthalten vorzugsweise Bor. Das Bor kann als Borid des Übergangsmetalls, Bornitrid des Übergangsmetalls und/oder atomares Bor an Gitterfehlstellen vorliegen. Vorzugsweise ist nur eine dünne Grenzschicht der Plättchen **34,** z.B. von weniger als 100 nm Stärke, borhaltig. Die Haftvermittlungsschicht **25** bindet die Diamantschicht **23** chemisch und mechanisch an das gesinterte Hartmetall des Grundkörpers **21** an.

Die Plättchen **34** bilden eine lenticulare Struktur mit sehr steilen Hängen. Die Plättchen **34** haben jeweils zwei gegenüberliegende weitgehend identischen Seitenflächen, die parallel oder leicht zueinander geneigt sind. Die Seitenflächen sind vertikal oder geneigt zu der mittleren Oberseite **22** des Grundkörpers **21** orientiert. Die Neigung der Seitenflächen ist größer als 60 Grad, vorzugsweise größer als 80 Grad. Eine Dicke des Plättchens ist durch den Abstand der Seitenflächen vorgegeben. Die Dicke ist deutlich geringer als die Länge und Höhe der Seitenflächen bzw. des Plättchens **34,** vorzugsweise ist die Höhe wenigstens doppelt, z.B. zehnfach, so groß wie die Breite. Die Länge der Plättchen **34** kann gleich oder größer als die Höhe sein. Die Plättchen **34** sind im Mittel zwischen 1 µm und 5 µm lang, 0,5 µm und 2 µm hoch und deutlich unter 0,7 µm breit. Fig. 6 zeigt eine Draufsicht auf die Haftvermittlungsschicht **25** mit den Plättchen **34.** Fig. 7 zeigt einen Ausschnitt in vergrößerter Darstellung von Fig. 6. Die Plättchen **34** haben schmale freiliegende Kanten, die in Wachstumsrichtung **26,** d.h. zu der Diamantschicht **23** hin, weisen. Die Plättchen **34** bedecken weitgehend die gesamte Kontaktseite **33,** vorzugsweise wenigstens 75 % derer Oberfläche. Die Kanten der Plättchen **34** bilden eine erhabene netzförmige Struktur. Die Plättchen **34** sind ohne erkennbare Regelmäßigkeit in unterschiedliche Richtungen in der Ebene der Haftvermittlungsschicht **25** orientiert. Die Plättchen **34** können unter verschiedenen Winkel aneinandergrenzen, die Winkel können beispielsweise im Bereich zwischen 20 Grad und 90 Grad liegen.

Die Diamantschicht **23** ist auf der Haftvermittlungsschicht **25,** insbesondere den Plättchen **34** abgeschieden. Die vorzugsweise borhaltigen Kanten der Plättchen **34** begünstigen die chemische Anbindung von Diamant auf der Haftvermittlungsschicht **25.** Die frei orientierten Plättchen **34** erhöhen die Haftfestigkeit zwischen der Diamantschicht **23** und dem Grundkörper **21.**

Die Diamantschicht **23** besteht aus zu mehr als 90% aus vielen einzelnen stabförmigen Kristallen, nachfolgend als Stängel **35** bezeichnet, welche sich durch Auswachsen der Nanodiamant-Keime bildet. Die erste Nanodiamantkeimschicht ist fest mit der Haftvermittlungsschicht **25** chemisch und mechanisch verankert. Die Stängel **35** sind vertikal zu der Kontaktseite **33** der Haftvermittlungsschicht **25,** d.h. der Oberseite **22,** orientiert. Die Stängel **35** grenzen aneinander an. Benachbarte Stängel sind durch zwischen ihnen ausgebildete Korngrenzflächen getrennt. Die Stängel **35** erstrecken sich in der Regel von der Nanodiamantkeimschicht bis zu der Schneidfläche **18,** d.h. eine Höhe der Stängel **35** ist gleich der Höhe **36** der Diamantschicht **23.** Die Diamantschicht **23** erweist sich als äußert belastbar in Hinblick auf Stöße. Die Diamantschicht **23** aus den Stängeln erweist sich als mechanisch stabil und robust gegenüber statischen und dynamischen Belastungen aus unterschiedlichen Richtungen und Schlägen. Die Diamantschicht **23** weist trotz der Stängelform eine sehr hohe Härte auf, welche für das Bearbeiten von harten mineralischen Werkstoffen notwendig ist.

Die Stängel **35** sind vorzugsweise sehr dünn. Das Aspektverhältnis der Stängel, d.h. das Verhältnis der Höhe zu dem Durchmesser ist größer drei, vorzugsweise größer fünf. Die dünnen Stängel erweisen sich als robuster gegenüber Schlagbelastungen. Der Durchmesser wird in einer Ebene parallel zu der Oberseite **22** und die Höhe senkrecht zu der Oberseite **22** bestimmt. Die dünnen Stängel **35** haben vorzugsweise eine Höhe von mehr als 10 µm, beispielsweise mehr als 20 µm, mehr als 40 µm. Eine Höhe **36** von bis zu 100 µm kann realisiert werden. Die Stängel **35** erstrecken sich über die gesamte Höhe **36** der Diamantschicht **23.** Der Durchmesser der Stängel liegt unter 10 µm, bevorzugt ist jedoch ein deutlich geringerer Durchmesser von unter 2 µm, weniger als 100 nm, und wenigstens 10nm. Die Stabilität der Stängel ergibt sich durch das Abstützen an benachbarten Stängel und der chemischen Bindung.

Die Stängel **35** der Diamantschicht **23** sind in ihren Abmessungen und der Kristallorientierung längs Wachstumsrichtung **26** über die gesamte Diamantschicht **23** homogen (Fig. 9). Beispielsweise weicht der Durchmesser von etwa 80 % der Stängel **35** um weniger als 50 % von dem mittleren Durchmesser der Stängel **35** ab. Die Stängel **35** haben ein dem Diamant entsprechendes kubisches Kristallgitter. Eine Kristallachse der Stängel **35** ist längs der Höhe **36** der Stängel **35** orientiert. Diese vertikale Kristallachse kann beispielsweise die [110]-Kristallachse oder die [111]-Kristallachse sein. Die Stängel **35** der Diamantschicht **23** haben weitgehend alle die gleiche vertikale Kristallachse. Die Kristallorientierung der Stängel **35** sind somit längs der Wachstumsrichtung **26** oder Höhe der Stängel **35** zueinander parallel.

Die Abscheidung (CVD-Verfahren) der Schichten erfolgt vorzugsweise in einem Reaktor. Die Haftvermittlungsschicht **25** aus Plättchen **34** kann auf eine Abfolge von zwei Zwischenschichten **24** aufgebracht werden. Auf den Grundkörper **21** wird zunächst eine Barriereschicht **31** und auf die Barriereschicht **31** eine kohlenstoffreiche Schicht aufgebracht, bevor die kohlenstofffreie Haftvermittlungsschicht **25** aufgebracht wird. Die beispielhaften Zwischenschichten **24** enthalten Titan als Basis für die Nitride und Karbide, insbesondere für die kohlenstoffhaltige Promotionsschicht **32** kann die Schicht neben Titan auch Tantal, Vanadium oder Chrom enthalten.

Die Barriereschicht **31** wird aus einer Gasphase mit Titan(IV)-chlorid (TiCl4), Stickstoff (N2) und Wasserstoff (H2) abgeschieden. Titan(IV)-chlorid hat einen Anteil von 1 Vol.-% bis 4 Vol.-%, Stickstoff und Wasserstoff sind etwa in gleichen Anteilen vorhanden. Die Abscheidung findet vorzugsweise bei einer vergleichsweise niederen Temperatur im Bereich von 750°C bis 850°C, z.B. bei 800°C statt. Der Druck in der Reaktionskammer liegt zwischen 550 mbar und 650 mbar, z.B. 600 mbar. Die Barriereschicht **31** wächst kontinuierlich als glatte Schicht auf. Die Abscheidung wird fortgesetzt, bis eine 0,1 µm und 0,5 µm dicke Barriereschicht **31** erreicht ist. Bei den genannten Wachstumsbedingungen dauert dies zwischen 60 und 90 Minuten.

Die Zusammensetzung der Gasphase wird für die Promotionsschicht **32** verändert. Die Gasphase enthält nun Titan(IV)-chlorid, Methan (CH4) und Wasserstoff (H2). Methan hat einen Anteil zwischen 5 Vol.-% und 10 Vol.-%, z.B. 7,5 Vol.-%. Titan(IV)-chlorid hat einen Anteil zwischen 2 Vol.-% und 8 Vol.-%., z.B. 4,5 Vol.-%. Das Verhältnis von Methan zu Titan(IV)-chlorid liegt näherungsweise bei 10 zu 6. Wasserstoff wird in großem Überschuss angeboten. Der Druck in der Reaktionskammer wird auf einen Bereich zwischen 70 mbar und 90 mbar, z.B. 80 mbar, abgesenkt. Die Temperatur wird vorzugsweise auf 950°C bis 1050°C, z.B. 1000°C angehoben. Die Abscheidung wird solange fortgesetzt, bis eine zwischen 1 µm und 2 µm dicke Promotionsschicht **32** abgeschieden ist. Bei den genannten Wachstumsparametern sind hierfür 10 min bis 20 min zu veranschlagen.

Die Haftvermittlungsschicht **25** wird anfänglich mit einer Niederdruckabscheidung auf die Promotionsschicht **32** begonnen. Die Gasphase enthält Titan(IV)-chlorid (TiCl4), Stickstoff (N2) und Wasserstoff (H2). Die Atmosphäre ist insbesondere frei von kohlenstoffhaltigen Gasen. Titan(IV)-chlorid hat einen Volumenanteil zwischen 0,5 Vol.-% und 4 Vol.-%, vorzugsweise einen Anteil zwischen 1,0 Vol.-% und 1,5 Vol.-%. Wasserstoff hat beispielsweise einen Volumenanteil zwischen 50 Vol.-% und 90 Vol.-%, Stickstoff hat beispielsweise einen Volumenanteil zwischen 15 Vol.-% und 40 Vol.-%. Stickstoff wird in der Gasphase in großem Überschuss zu dem Titan(IV)-chlorid angeboten. In einem Beispiel sind die relativen Anteile: 240 Volumeneinheiten Wasserstoff, 50 Volumeneinheiten Stickstoff und 4 Volumeneinheiten Titan(IV)-chlorid. Der Druck in der Reaktionskammer liegt bei 550 mbar bis 650 mbar, z.B. 600 mbar. Die Temperatur wird auf hohen Niveau zwischen 950°C und 1050°C, z.B. 1000°C, gehalten. Die Abscheidung erfolgt für etwa 60 Minuten bis 120 Minuten, um eine zwischen 2 µm und 3 µm dicke Titannitridschicht zu erhalten. Die Plättchen **34** haben eine Höhe von 1 µm bis 2 µm.

Die optionale Borierung der Plättchen **34** erfolgt mit einer geänderten Zusammensetzung der Atmosphäre, indem zu Titan(IV)-chlorid (TiCl4), Stickstoff (N2) und Wasserstoff (H2) noch Bortrichlorid (BCl3) eingeleitet wird. Das Borchlorid hat einen Anteil von 0,1 % und 0,4 %, die Gasanteile von TiCl4, N2 und H2 bleiben gegenüber der vorhergehenden Abscheidung der Plättchen **34** unverändert. Ebenso bleibt die Temperatur auf dem angehobenen Niveau. Der Druck wird auf 550 mbar bis 650 mbar, z.B. 600 mbar, erhöht. Die Plättchen **34** aus Titannitrid wachsen weiter. An den Kanten der Plättchen **34** scheidet sich Kristalle aus Titanborverbindungen ab, hingegen im Wesentlich nicht auf den Seitenflächen der Plättchen **34.** Die Seitenflächen bleiben somit aus reinem Titannitrid. Die Abscheidung wird nach 10 Minuten beendet. Die Schichtdicke der Titanboridverbindungen liegt im Bereich zwischen 10 nm und 200 nm.

Die Diamantschicht **23** wird auf die Plättchen **34** oder borierten Plättchen **34** abgeschieden. Die Haftvermittlungsschicht **25** wird mit Nanodiamantpulver bekeimt. Das Wachstum der stabförmigen Diamantkristalle erfolgt aus der Gasphase (CVD-Verfahren). Die Atmosphäre enthält Methan (CH4) und Wasserstoff (H2). Der Metangehalt liegt mit 2,5 Vol.-% bis 4,0 Vol.-%, z.B. 2,9 Vol.-%, höher als bei der Abscheidung gemäß dem ersten Verfahren. Der Druck liegt zwischen 2 mbar und 20 mbar, vorzugsweise zwischen 5 mbar bis 8 mbar. Die Abscheidungstemperatur liegt im Bereich zwischen 700°C und 850°C, z.B. bei 750°C. Der hohe Methangehalt in der Gasphase führt vermehrt zu sekundärer Keimbildung während des Diamantwachstums, was den Korndurchmesser quer zur Wachstumsrichtung bis in den Nanometerbereit reduziert. Trotzdem liegt teilweise noch Stängel-förmiges Wachstum vor. Es ergeben sich jedoch mehr Korngrenzen und in Folge wesentlich dünnere Stängel **35.** Die Diamantschicht **23** kann auch bei einem geringeren Methangehalt zwischen 0,8 Vol.-% bis 1,6 Vol.-% abgeschieden werden, um breitere Stängel zu erhalten.

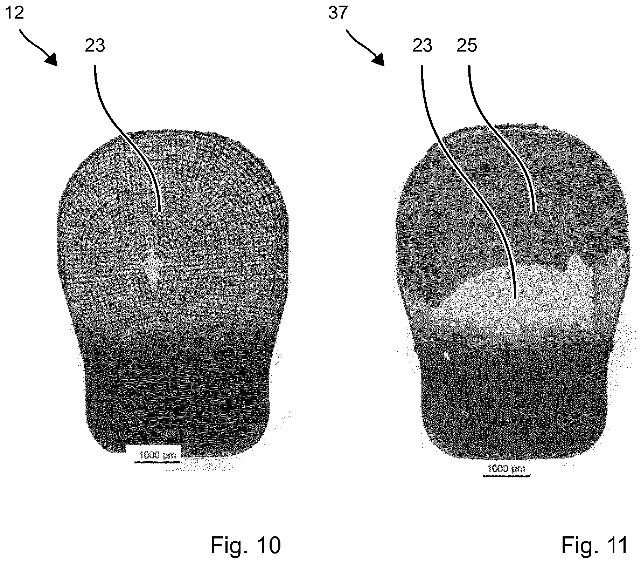

Fig. 10 zeigt eine Schneidplatte **12,** deren Grundkörper **21** mit der zuvor beschriebenen Struktur aus Erhebungen **27** und Gräben **28** versehen ist. Die Struktur ist auch bei der aufgewachsenen Diamantschicht **23** noch zu sehen. Fig. 11 zeigt eine Schneidplatte **37,** welche ohne regelmäßige Struktur auf dem Grundkörper **21** hergestellt wurde. Beide Schneidplatten **12** haben die gleiche chemische Zusammensetzung, die Haftvermittlungsschicht **25** und die Diamantschicht **23** wurden unter gleichen Bedingungen hergestellt. Beide Schneidplatten **12** wurden in gleicher Weise belastet. Erkennbar hat sich die Diamantschicht **23** von dem unstrukturierten Grundkörper **21** bereits abgelöst, während die Diamantschicht **23** auf dem strukturierten Grundkörper **21** noch hält.

Die chemische Zusammensetzung des Grundkörpers **21** hat einen Einfluss auf die Stabilität der Diamantschicht **23.** Vergleichsversuche zeigen, dass Grundkörper **21** vorzugsweise einen Wolframkarbidanteil von wenigstens 85 Gew.-%, z.B. mehr als 92 Gew.-% aufweisen sollten. Der bevorzugte metallische Binder ist Kobalt oder eine Kobalt-basierte Legierung mit einem Anteil von wenigstens 50 Gew.-% Kobalt.

Die gesamte Oberseite **22** der Schneidplatte **12** kann strukturiert und mit der Diamantschicht **23** überzogen sein. Je nach Einbau der Schneidplatte **12** in das Werkzeug **2** wird nur ein Arbeitsabschnitt der Oberseite **22** für die Bearbeitung eines Untergrunds **11** genutzt (vgl. Fig. 10). Während ein anderer (Befestigungs-) Abschnitt der Oberseite **22** für die Befestigung der Schneidplatte **12** in dem Werkzeug **2** dienen kann. Der Arbeitsabschnitt ist strukturiert und mit der Diamantschicht **23** versehen, der Befestigungsabschnitt ist vorzugsweise unstrukturiert und ohne Diamantschicht **23.**

Die Mantelfläche **20** der Schneidplatte **12** kann ebenfalls strukturiert und mit der Diamantschicht **23** versehen sein. Insbesondere ist ein Abschnitt der Mantelfläche **20,** welcher mit einer Kante an den Arbeitsabschnitt angrenzt, strukturiert und beschichtet. Die Diamantschichten an den weitgehend senkrecht aneinander angrenzenden Flächen stützen sich gegenseitig im Bereich der Kante. Ein Abspringen der Diamantschicht **23** ausgehend von der Kante kann hierdurch verringert werden. Die Struktur mit den Erhebungen **27,** die Zwischenschichten **24** und die Diamantschicht **23** auf der Oberseite **22** und der Mantelfläche **20** sind vorzugsweise gleich. Die Mantelfläche **20** kann über die gesamte Höhe der Schneidplatte **12** strukturiert und beschichtet sein, d.h. von der Oberseite **22** bis zu der Rückseite **19.**

## Patentansprüche

1. Herstellungsverfahren für eine Schneidplatte (12), insbesondere eine Schneidplatte (12) für eine Kernbohrkrone (2), mit den Schritten:
Formen eines Grundkörpers (21) der Schneidplatte (12) aus einem Hartmetall,
Strukturieren einer Oberseite (22) unter Ausbildung von Erhebungen (27), deren mittlerer Abstand (29) zwischen 50 µm und 250 µm beträgt und deren Höhe zwischen 12,5 % und 50 % des mittleren Abstands (29) beträgt,
Abscheiden von ein oder mehreren Zwischenschichten (24) einschließlich einer Haftvermittlungsschicht (25) auf der Oberseite (22) des Grundkörpers (21) mittels eines Gasabscheideverfahrens (CVD), wobei das Abscheiden der Haftvermittlungsschicht (25) aus Nitriden von Übergangsmetallen die Schritte umfasst: Abscheiden von Nitriden eines oder mehrerer Übergangsmetalle aus der Gruppe IV, Gruppe V und Gruppe VI des Periodensystems bei einer Temperatur zwischen 950°C und 1100°C zum Ausbilden einer Vielzahl zu der Oberseite (22) geneigt orientierter Plättchen (34), welche aus den Nitriden der Übergangsmetalle bestehen und;
Aufwachsen einer Diamantschicht (23) auf der Haftvermittlungsschicht (25), welches die Schritte umfasst:
Bekeimen der Haftvermittlungsschicht (25) mit Diamantstaub und
Aufwachsen von Stängel-förmigen Diamanten aus der Gasphase auf der Haftvermittlungsschicht (25).

2. Herstellungsverfahren nach Anspruch 1, **dadurch kennzeichnet, dass** die strukturierte Oberseite (22) vor dem Abscheiden mit einem Partikelstrahlverfahren mit einem festen Strahlmittel bearbeitet wird, bis eine gemittelte Rautiefe Rz für eine Messstrecke mit einer Länge von 800 µm wenigstens 5 µm beträgt.

3. Herstellungsverfahren nach Anspruch 1, **dadurch kennzeichnet, dass** der Grundkörper (21) vor dem Strukturieren gesintert wird.

4. Herstellungsverfahren nach Anspruch 1, **dadurch kennzeichnet, dass** der Grundkörper (21) nach dem Strukturieren gesintert wird.

5. Herstellungsverfahren nach Anspruch 1, **dadurch kennzeichnet, dass** das Abscheiden der Haftvermittlungsschicht (25) ein Abscheiden eines Borids und/oder Bornitrids der ein oder mehreren Übergangsmetalle beinhaltet.

6. Schneidplatte (12) mit
einem Grundkörper (21) aus einem gesinterten Hartmetall, einer strukturierten Oberseite (22) des Grundkörpers (21), die Erhebungen in einem mittleren Abstand (29) von 50 µm bis 250 µm und einer Höhe (30) zwischen 12,5 % und 50 % des mittleren Abstands (29) aufweist,
ein oder mehreren Zwischenschichten (24) auf einer Oberseite (22) des Grundkörpers (21), wobei die Zwischenschichten eine Haftvermittlungsschicht (25) aufweisen, welche aus einem Nitrid eines Übergangsmetalls der Gruppe IV, Gruppe V und Gruppe VI Gruppe besteht und eine Vielzahl zu der Oberseite (22) geneigt orientierter Plättchen (34) enthält,
einer auf der Haftvermittlungsschicht (25) aufgewachsenen Diamantschicht, wobei die Diamantschicht (23) aus zu der Oberseite (22) vertikal orientierten, Stängel-förmigen Kristallen besteht.

7. Schneidplatte (12) nach Anspruch 6, wobei die Diamantschicht (23) aus zu der Oberseite (22) vertikal orientierten, Stängel-förmigen Kristallen besteht, deren Aspektverhältnis größer fünf ist.

8. Schneidplatte (12) nach Anspruch 6, **dadurch kennzeichnet, dass** die Oberseite (22) des Grundkörpers (21) eine gemittelte Rautiefe Rz für eine Messstrecke mit einer Länge von 800 µm wenigstens 5 µm beträgt.

9. Schneidplatte (12) nach Anspruch 6 oder 8, **dadurch kennzeichnet, dass** die zu der Oberseite (22) vertikalen Kristallachsen der Stängel-förmigen Kristallen (35) identisch sind.

10. Schneidplatte (12) nach Anspruch 6 bis 9, **dadurch kennzeichnet, dass** die Höhe (36) der Diamantschicht (23) gleich der Höhe der Stängel-förmigen Kristalle ist.

11. Schneidplatte (12) nach Anspruch 6 bis 10, **dadurch kennzeichnet, dass** die Stängel-förmigen Kristalle einen homogenen Durchmesser aufweisen.

12. Schneidplatte (12) nach Anspruch 6 bis 11, **dadurch kennzeichnet, dass** benachbarte Stängel-förmigen Kristalle über eine Korngrenze aneinander angrenzen.

13. Schneidplatte (12) nach Anspruch 6 bis 12, **dadurch kennzeichnet, dass** wenigstens ein an die Oberseite (22) angrenzender Abschnitt einer Mantelfläche (20) des Grundkörpers (21) gleich der Oberseite (22) strukturiert, ein oder mehrere der Zwischenschichten aufweist und mit der Diamantschicht (23) versehen ist.

## Claims

1. Production method for a cutting insert (12), in particular a cutting insert (12) for a core drill bit (2), comprising the steps of:
forming a basic body (21) of the cutting insert (12) from a hard metal,
structuring an upper side (22) while forming elevations (27), the average spacing (29) of which is between 50 µm and 250 µm and the height of which is between 12.5% and 50% of the average spacing (29),
depositing one or more intermediate layers (24), including an adhesion promoting layer (25), on the upper side (22) of the basic body (21) by means of a chemical vapour deposition process (CVD), the depositing of the adhesion promoting layer (25) of nitrides of transition metals comprising the steps of: depositing nitrides of one or more transition metals from the group IV, group V and group VI of the periodic table at a temperature of between 950°C and 1100°C to form a plurality of platelets (34), which are oriented such that they are inclined in relation to the upper side (22) and consist of the nitrides of the transition metals, and;
growing a diamond layer (23) on the adhesion promoting layer (25), which comprises the steps of:
seeding the adhesion promoting layer (25) with diamond dust and
growing rod-shaped diamonds from the vapour phase on the adhesion promoting layer (25).

2. Production method according to Claim 1, **characterized in that**, before the depositing, the structured upper side (22) is worked with a solid abrasive by a particle blasting process until an average peak-to-valley height Rz for a measuring length of 800 µm is at least 5 µm.

3. Production method according to Claim 1, **characterized in that** the basic body (21) is sintered before the structuring.

4. Production method according to Claim 1, **characterized in that** the basic body (21) is sintered after the structuring.

5. Production method according to Claim 1, **characterized in that** the depositing of the adhesion promoting layer (25) comprises depositing a boride and/or boron nitride of the one or more transition metals.

6. Cutting insert (12) with
a basic body (21) of a sintered hard metal, a structured upper side (22) of the basic body (21), which has elevations at an average spacing (29) of 50 µm to 250 µm and a height (30) of between 12.5% and 50% of the average spacing (29),
one or more intermediate layers (24) on an upper side (22) of the basic body (21), intermediate layers having an adhesion promoting layer (25), which consists of a nitride of a transition metal of the group IV, group V and group VI and contains a plurality of platelets (34) oriented such that they are inclined in relation to the upper side (22),
a diamond layer grown on the adhesion promoting layer (25), the diamond layer (23) consisting of rod-shaped crystals oriented vertically in relation to the upper side (22).

7. Cutting insert (12) according to Claim 6, the diamond layer (23) consisting of rod-shaped crystals which are oriented vertically in relation to the upper side (22) and the aspect ratio of which is greater than five.

8. Cutting insert (12) according to Claim 6, **characterized in that** the upper side (22) of the basic body (21) has an average peak-to-valley height Rz for a measuring length of 800 µm of at least 5 µm.

9. Cutting insert (12) according to Claim 6 or 8, **characterized in that** the vertical crystal axes, in relation to the upper side (22), of the rod-shaped crystals (35) are identical.

10. Cutting insert (12) according to Claims 6 to 9, **characterized in that** the height (36) of the diamond layer (23) is equal to the height of the rod-shaped crystals.

11. Cutting insert (12) according to Claims 6 to 10, **characterized in that** the rod-shaped crystals have a homogeneous diameter.

12. Cutting insert (12) according to Claims 6 to 11, **characterized in that** adjacent rod-shaped crystals adjoin each other over a grain boundary.

13. Cutting insert (12) according to Claims 6 to 12, **characterized in that** at least a portion of a lateral surface (20) of the basic body (21) that is adjacent to the upper side (22) is structured identically to the upper side (22), has one or more of the intermediate layers and is provided with the diamond layer (23).

## Revendications

1. Procédé de fabrication pour une plaque de découpage (12), en particulier une plaque de découpage (12) pour une couronne de carottage (2), comportant les étapes de :
formation d'un corps de base (21) de la plaque de découpage (12) à partir d'un métal dur,
structuration d'une face supérieure (22) avec formation de saillies (27), dont la distance moyenne (29) est comprise entre 50 µm et 250 µm et dont la hauteur est comprise entre 12,5 % et 50 % de la distance moyenne (29),
dépôt d'une ou plusieurs couches intermédiaires (24) y compris d'une couche adhésive (25) sur la face supérieure (22) du corps de base (21) au moyen d'un procédé de dépôt en phase gazeuse (CVD), le dépôt de la couche adhésive (25) en nitrures de métaux de transition comprenant les étapes de : dépôt de nitrures d'un ou plusieurs métaux de transition du groupe IV, du groupe V et du groupe VI du système périodique à une température comprise entre 950 °C et 1 100 °C pour la formation d'une pluralité de plaquettes (34) orientées de manière inclinée par rapport à la face supérieure (22), qui sont constituées des nitrures des métaux de transition et ;
croissance d'une couche de diamant (23) sur la couche adhésive (25), qui comprend les étapes de :
ensemencement de la couche adhésive (25) avec de la poussière de diamant et
croissance de diamants en forme de tige à partir de la phase gazeuse sur la couche adhésive (25).

2. Procédé de fabrication selon la revendication 1, **caractérisé en ce que** la face supérieure structurée (22) est traitée, avant le dépôt, par un procédé de faisceau de particules avec un abrasif solide, jusqu'à ce qu'une rugosité moyenne Rz pour une section de mesure d'une longueur de 800 µm soit d'au moins 5 µm.

3. Procédé de fabrication selon la revendication 1, **caractérisé en ce que** le corps de base (21) est fritté avant la structuration.

4. Procédé de fabrication selon la revendication 1, **caractérisé en ce que** le corps de base (21) est fritté après la structuration.

5. Procédé de fabrication selon la revendication 1, **caractérisé en ce que** le dépôt de la couche adhésive (25) contient un dépôt d'un borure et/ou d'un nitrure de bore de l'un ou des métaux de transition.

6. Plaque de découpage (12) comportant
un corps de base (21) composé d'un métal dur fritté, d'une face supérieure structurée (22) du corps de base (21), qui présente des saillies d'une distance moyenne (29) de 50 µm à 250 µm et d'une hauteur (30) comprise entre 12,5 % et 50 % de la distance moyenne (29),
une ou plusieurs couches intermédiaires (24) sur une face supérieure (22) du corps de base (21), les couches intermédiaires présentant une couche adhésive (25) qui est constituée d'un nitrure d'un métal de transition du groupe IV, du groupe V et du groupe VI et contient une pluralité de plaquettes (34) orientées de manière inclinée par rapport à la face supérieure (22),
une couche de diamant qui a crû sur la couche adhésive (25), la couche de diamant (23) étant constituée de cristaux en forme de tige, orientés verticalement par rapport à la face supérieure (22).

7. Plaque de découpage (12) selon la revendication 6, la couche de diamant (23) étant constituée de cristaux en forme de tige, orientés verticalement par rapport à la face supérieure (22), dont le rapport d'aspect est supérieur à cinq.

8. Plaque de découpage (12) selon la revendication 6, **caractérisée en ce que** la face supérieure (22) du corps de base (21) possède une rugosité moyenne Rz pour une section de mesure d'une longueur de 800 µm d'au moins 5 µm.

9. Plaque de découpage (12) selon la revendication 6 ou 8, **caractérisée en ce que** les axes cristallins verticaux par rapport à la face supérieure (22) des cristaux (35) en forme de tige sont identiques.

10. Plaque de découpage (12) selon les revendications 6 à 9, **caractérisée en ce que** la hauteur (36) de la couche de diamant (23) est égale à la hauteur des cristaux en forme de tige.

11. Plaque de découpage (12) selon les revendications 6 à 10, **caractérisée en ce que** les cristaux en forme de tige présentent un diamètre homogène.

12. Plaque de découpage (12) selon les revendications 6 à 11, **caractérisée en ce que** des cristaux en forme de tige adjacents sont adjacents les uns des autres par une limite granulaire.

13. Plaque de découpage (12) selon les revendications 6 à 12, **caractérisée en ce qu'**au moins une section adjacente à la face supérieure (22) d'une surface d'enveloppe (20) du corps de base (21) est structurée comme la face supérieure (22), présente une ou plusieurs des couches intermédiaires et est pourvue de la couche de diamant (23).
